Europäisches Patentamt

European Patent Office

Office européen des brevets

(11) Veröffentlichungsnummer: **0 358 867**
**A1**

(12) **EUROPÄISCHE PATENTANMELDUNG**

(21) Anmeldenummer: **89111437.3**

(22) Anmeldetag: **23.06.89**

(51) Int. Cl.5: **H01L 21/60 , H01L 21/58 , H05K 3/34**

Die Bezeichnung der Erfindung wurde geändert (Richtlinien für die Prüfung im EPA, A-III, 7.3).

(30) Priorität: **15.07.88 DE 3824008**

(43) Veröffentlichungstag der Anmeldung:
**21.03.90 Patentblatt 90/12**

(84) Benannte Vertragsstaaten:
**CH DE FR GB LI SE**

(71) Anmelder: **CONTRAVES AG**
**Schaffhauserstrasse 580**
**CH-8052 Zürich(CH)**

(72) Erfinder: **Berner, Gianni, Dr.**
**Eichtalhöhe 18**
**CH-5400 Baden(CH)**

(74) Vertreter: **Lück, Gert, Dr. rer. nat. et al**
**c/o ASEA BROWN BOVERI AG**
**Patentabteilung**
**CH-5401 Baden(CH)**

(54) **Flip-Chip-Montage mit einer Lötstoppschicht aus einem oxidierbaren Metall.**

(57) Bei einer elektronischen Schaltung mit Flip-Chip-Montage eines Halbleiterchips(5) auf einem Substrat-(1) wird zwischen dem Halbleiterchip(5) und den Leiterbahnen(2) des Substrats(1) eine metallische Lötstoppschicht(3) vorgesehen, die von ihrer Umgebung durch eine Oxidschicht(4) isoliert ist.

Mit dieser Art von Lötstoppschicht lassen sich genau reproduzierbare Schichdicken erzielen, wodurch eine zuverlässige Flip-Chip-Lötung erreicht wird.

FIG.5

EP 0 358 867 A1

## Elektronische Schaltung sowie Verfahren zu deren Herstellung

Technisches Gebiet

Die vorliegende Erfindung bezieht sich auf das Gebiet der Mikroelektonik. Sie betrifft insbesondere eine elektronische Schaltung gemäss dem Oberbegriff des Anspruchs 1 sowie ein Verfahren zu deren Herstellung. Schaltungen dieser Art sind aus dem Stand der Technik unter der Bezeichnung "Flip-Chip"-Montage bekannt.

Stand der Technik

Beim Auflöten von Flip-Chips (das sind "nackte" Halbleiterchips mit Lotkügelchen (sog.Bumps) als kontaktierungselementen) auf ein mit Leiterbahnen versehenes Substrat ist die Verwendung einer Lötstoppschicht vorteilhaft und bekannt.

Diese Lötstoppschicht verhindert, dass das Lot entlang den Leiterbahnen auseinanderfliesst und damit der Halbleiterchip auf dem Substrat zu liegen kommt und ungewollte Kurzschlüsse verursacht.

Für die Lötstoppschicht wird herkömmlicherweise ein organischer Lötstopplack verwendet, der meistens im Siebdruckverfahren oder als photolithographisch verarbeitbare Flüssigkeit oder Folie auf das Substrat aufgebracht wird.

Ein solcher Lötstopplack bringt beim Flip-Chip-Lötverfahren jedoch folgende Nachteile:
- eine schlechte Temperaturbeständigkeit; und
- zu hohe, nicht genau reproduzierbare Schichtdikken.

Da beim Fixieren der Flip-Chips die Kanten der Lötstoppschicht zugleich der Justierung des Chips auf dem Substrat dienen, hat eine nicht reproduzierbare Schichtdicke folgende Konsequenzen:
- ist die Schichtdicke zu gering, geht die Justierwirkung der Kanten verloren;
- ist die Dicke dagegen zu gross, wird die Lötung unregelmässig und führt zu einem mangelnden Kontakt zwischen Chip und Substrat.

Darstellung der Erfindung

Aufgabe der Erfindung ist es daher, eine elektronische Schaltung zu schaffen, bei der eine gleichmässige und zuverlässige Flip-Chip-Montage gewährleistet ist, sowie eine Verfahren zu Herstellung einer solchen Schaltung anzugeben.

Die Aufgabe wird bei einer Schaltung der eingangs genannten Art durch die Merkmale aus dem Kennzeichen des Anspruchs 1 gelöst.

Der Kern der Erfindung besteht darin, die nicht reproduzierbare organische Lötstoppschicht durch eine einfach und gleichmässig abzuscheidende metallische Lötstoppschicht zu ersetzen. Der notwendige Isolationsschutz wird dabei durch eine Oxidschicht auf der Oberfläche der Lötstoppschicht erreicht.

Gemäss einem bevorzugten Ausführungsbeispiel wird als Metall Nickel verwendet und die Oxidschicht durch Oxidation des Nickels erzeugt.

Das erfindungsgemässe Verfahren ist gekennzeichnet durch die Merkmale des Anspruchs 3.

Weitere Ausführungsbeispiele der Erfindung ergeben sich aus den Unteransprüchen.

Kurze Beschreibung der Zeichnung

Die Erfindung soll nachfolgend im Zusammenhang mit der Zeichnung anhand von Ausführungsbeispielen näher erläutert werden. Es zeigen

Fig.1-5 verschiedene Schritte bei der Herstellung einer elektronischen Schaltung gemäss einem Ausführungsbeispiel der Erfindung; und

Fig.5 eine fertige elektronische Schaltung gemäss einem Ausführungsbeispiel der Erfindung.

Wege zur Ausführung der Erfindung

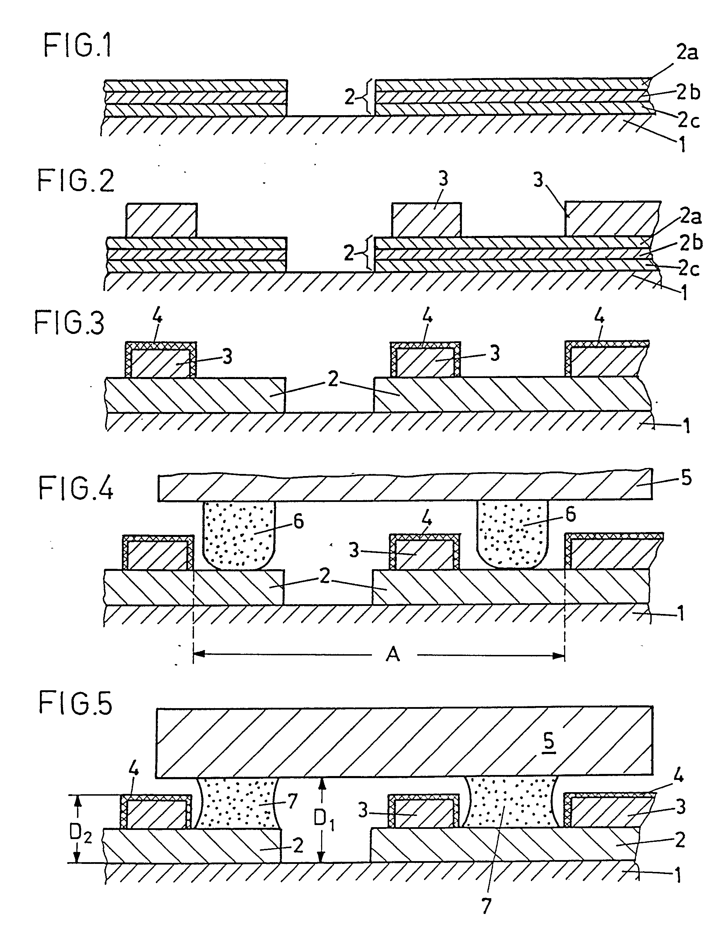

Bei der Herstellung einer elektronischen Schaltung mit Flip-Chip-Montage geht die Erfindung zunächst von einem Substrat 1 aus, auf dessen Oberseite mit vorgegebener Struktur Leiterbahnen 2 aufgebracht werden (Fig.1).

Die Leiterbahnen 2 haben dabei z.B. einen dreischichtigen Aufbau mit einer untenliegenden Haftschicht 2c (aus NiCr, Cr oder ähnlichen Metallen), einer mittleren Diffusionssperrschicht 2b (aus Ni oder ähnlichen Metallen) und einer Leiterschicht 2a (aus Cu, Au oder ähnlichen Metallen).

Auf die Leiterbahnen 2 wird nun, vorzugsweise durch galvanisches Abscheiden, eine strukturierte metallische Lötstoppschicht 3 (vorzugsweise aus Ni) aufgebracht(Fig.2). Diese Lötstoppschicht 3 enthält an den Stellen, an denen später die leitende Verbindung zu einem Halbleiterchip hergestellt werden soll. Aussparungen, die gleichzeitig zum Justieren des Chips dienen.

Nachdem die Lötstoppschicht 3 abgeschieden worden ist, wird auf ihrer Oberfläche durch Oxidation eine Oxidschicht 4 erzeugt, welche die Lötstoppschicht 3 von ihrer Umgebung elektrisch isoliert und sicherstellt, dass kein unerwünschter Kontakt zum später darüberliegenden Halbleiterchip zustandekommt(Fig.3).

Die Oxidation kann auf verschiedene Weise durchgeführt werden: Eine Möglichkeit ist die thermische Oxidation durch Erhitzen des beschichteten Substrats in einer sauerstoffhaltigen Atmosphäre. Eine weitere Möglichkeit ist die Einwirkung eines sauerstoffhaltigen Plasmas auf die Oberfläche der Lötstoppschicht 3. Eine dritte Möglichkeit ist die nasschemische Oxidation in einem geeigneten chemischen Bad. Jede dieser drei Möglichkeiten hat dabei ihre eigenen Vorzüge und Nachteile.

Wenn die Lötstoppschicht 3 soweit vorbereitet ist, wird ein nackter Halbleiterchip 5, der auf seiner Unterseite mit Lotkugeln in Form von ßumps 6 versehen ist, auf das Substrat 1 gesetzt (Fig.4). Die Bumps 6 greifen dabei in die vorbereiteten Aussparungen in der Lötstoppschicht 3 ein und werden durch einen vorgegebenen Justierabstand A dieser Aussparungen justiert.

Nach der Justierung wird die ganze Anordnung soweit erwärmt, dass das Lot der ßumps 6 schmilzt und eine feste Lotverbindung 7 zwischen dem Halbleietrchip 5 und den Leiterbahnen 2 bildet (Fig.5). Das Lot breitet sich dabei etwas aus, wird jedoch von der Lötstoppschicht 3 in seiner Ausbreitung begrenzt und hält infolge der Oberflächenspannung den Halbleiterchip 5 auf einem Abstand D1, der grösser ist als der Abstand D2 der oberen Oxidschicht 4 von Substrat 1.

Da sich mit der metallischen Lötstoppschicht sehr leicht genau reproduzierbare Dicken einstellen lassen, ergibt sich mit der Erfindung eine besonders zuverlässige elektronische Schaltung.

## Ansprüche

1. Elektronische Schaltung, umfassend
(a) ein Substrat(1) mit einer Oberseite und einer Unterseite und einer Mehrzahl von Leiterbahnen(2), welche auf die Oberseite des Substrats(1) aufgebracht sind;
(b) einen Halbleiterchip(5), welcher in einem Abstand(D1) vom Substrat(1) auf dessen Oberseite angeordnet und an vorgegebenen Stellen mit den Leiterbahnen(2) durch Lotverbindungen(7) elektrisch verbunden ist; und
(c) eine Lötstoppschicht(3) zwischen den Leiterbahnen(2) und dem Substrat(1), welche Lötstoppschicht(3) die Lotverbindungen(7) umschliesst;
dadurch gekennzeichnet, dass
(d) die Lötstoppschicht(3) aus einem oxidierbaren Metall besteht; und
(e) die Lötstoppschicht(3) an der Oberfläche mit einer Oxidschicht(4) bedeckt ist.

2. Elektronische Schaltung nach Anspruch 1, dadurch gekennzeichnet, dass

(a) die Lötstoppschicht(3) aus Nickel besteht; und
(b) die Oxidschicht(4) Nickeloxid enthält.

3. Verfahren zur Herstellung einer elektronischen Schaltung nach Anspruch 1, gekennzeichnet durch die folgenden Schritte:
(a) das Substrat(1) wird auf der Oberseite mit den Leiterbahnen(2) versehen;
(b) auf die Leiterbahnen(2) wird die Lötstoppschicht(3) in Form einer strukturierten Metallschicht aufgebracht;
(c) auf der Oberfläche der Lötstoppschicht(3) wird durch Oxidation die Oxidschicht(4) erzeugt;
(d) der Halbleiterchip(5), welcher auf seiner Unterseite mit Bumps(6) aus Lot versehen ist, wird mit diesen Bumps(6) auf die Leiterbahnen(2) gesetzt und mittels der Lötstoppschicht(3) justiert; und
(e) durch Erwärmen der Bumps(6) werden die Lotverbindungen(7) zwischen Halbleiterchip(5) und den Leiterbahnen(2) hergestellt.

4. Verfahren nach Anspruch 3, dadurch gekennzeichnet, dass die Lötstoppschicht(3) galvanisch aufgebracht wird.

5. Verfahren nach Anspruch 4, dadurch gekennzeichnet, dass als Metall für die Lötstoppschicht(3) Nickel verwendet wird.

6. Verfahren nach Anspruch 5, dadurch gekennzeichnet, dass die Oxidschicht(4) durch thermische Oxidation hergestellt wird.

7. Verfahren nach Anspruch 5, dadurch gekennzeichnet, dass die Oxidschicht(4) durch Plasmaeinwirkung auf die Lötstoppschicht(3) erzeugt wird.

8. Verfahren nach Anspruch 5, dadurch gekennzeichnet, dass die Oxidschicht(4) durch nasschemische Oxidation hergestellt wird.

FIG.1

FIG.2

FIG.3

FIG.4

FIG.5

## EINSCHLÄGIGE DOKUMENTE

| Kategorie | Kennzeichnung des Dokuments mit Angabe, soweit erforderlich, der maßgeblichen Teile | Betrifft-Anspruch | KLASSIFIKATION DER ANMELDUNG (Int. Cl.5) |
|---|---|---|---|
| X | IBM JOURNAL OF RESEARCH AND DEVELOPMENT Mai 1969, Seiten 239-250, New York, USA; L.F. MILLER: "Controlled Collapse Reflow Chip Joining" * Seite 242, rechte Spalte, zweiter Absatz; Seite 248, rechte Spalte; Figur 3a" * | 1,3 | H 01 L 21/60<br>H 01 L 21/58<br>H 05 K 3/34 |
| A | idem<br>--- | 2,4-8 | |
| A | DE-A-3 305 952 (ETA)<br>* Zusammenfassung; Figuren 1-5 *<br>--- | 1,3 | |
| A | PATENT ABSTRACTS OF JAPAN Band 2, Nr. 68 (E-78)(2515), 24. Mai 1978; & JP - A - 53 35382 (SANYO DENKI) 04.01.1978<br>--- | 1,3 | |
| A | PATENT ABSTRACTS OF JAPAN Band 4, Nr. 133 (E-26)(615), 18. September 1980; & JP - A - 55 86130 (HITACHI SEISAKUSHO) 28.06.1980<br>----- | 1,3 | RECHERCHIERTE SACHGEBIETE (Int. Cl.5)<br><br>H 01 L 21/00<br>H 01 L 23/00<br>H 05 K 3/00 |

Der vorliegende Recherchenbericht wurde für alle Patentansprüche erstellt

| Recherchenort | Abschlußdatum der Recherche | Prüfer |
|---|---|---|
| BERLIN | 09-10-1989 | LE MINH I |